# EUROPEAN PATENT APPLICATION

(11) **EP 3 450 479 A1**
(43) Date of publication of application: **06.03.2019**
(21) Application number: 17188938.9
(22) Date of filing: 01.09.2017
(51) Int. Cl.: C08G 59/50

(54) **A LATENT, FAST CURING COMPOSITION, A USE THEREOF AND AN ARTICLE HAVING A CURED COMPOSITION OBTAINABLE THEREFROM**

(71) Applicant: Henkel AG & Co. KGaA, 40589 Düsseldorf (DE)
(72) Inventor: LIM, Jin Hong, Geumcheon-gu, Seoul (KR); KIM, Chong Youp, Gangnam-gu, Seoul 06219 (KR); SONG, Jung Ho, 10908 Paju City (KR); YEOM, Jae Gwan, Yeongeungpo-gu, Seoul (KR)

(57) **Abstract**

The problem to be solved by the present invention is the provision of an epoxy resin-based latent curing composition having fast cure performance. The solution therefor is a latent curing composition comprising (A) an epoxy resin; and (B) an imidazole curing agent having at least one primary amine group.

## Description

### Technical Field

The present invention relates to a latent curing composition, a use thereof, and an article having a cured composition obtainable therefrom.

### Background Art

In some applications for adhesives, such as thermocompression (TC) bonding and the like, fast curing performance is required.

Moreover, compared to a two-component-type curing system, wherein the addition of a curing agent or a curing accelerator is required immediately before use, a one-component-type curing system, i.e., a latent curing composition that is not cured at room temperature but at a somewhat higher temperature, is advantageous. Specifically, in such a one-component-type curing system, there is no need to measure and blend each component before use.

Curing systems based on an acrylic resin or a hybrid resin containing an acrylic resin have been used to achieve such fast curing and latent performance, since the radical polymerization of an acrylic resin leads to such desired fast cure performance (PTL 1).

On the other hand, epoxy resins are widely used in curing systems due to plural benefits such as physical, chemical, and electrical properties. Specifically, due to their excellent non-conductivity, and water and chemical resistance, as well as their mechanical and adhesion properties, epoxy resin curing systems are particularly suitable for nonconductive adhesives (NCA) for electronic devices, such as electronic circuits.

However, to the inventors' knowledge, due to the slow curing speed of epoxy resins, an epoxy resin-based latent curing composition having fast cure performance has not been suggested.

### Citation List

### Patent Literature

PTL 1: US 5865936 A

### Summary of Invention

### Technical Problem

A problem to be solved by the present invention is the provision of an epoxy resin-based latent curing composition having fast cure performance.

### Solution to Problem

The present inventors found that the above problem can be solved by a latent curing composition comprising (A) an epoxy resin and (B) an imidazole curing agent having at least one primary amine group.

Specifically, among various curing agents that were tested, a particular type of imidazole curing agent was found to be able to impart a fast cure and latent performance to an epoxy resin-based curing composition.

### Advantageous Effects of Invention

According to the present invention, an epoxy resin-based latent curing composition having fast cure performance, while retaining the advantageous properties resulting from epoxy resin, such as adhesive properties (e.g., die shear strength), non-conductivity, and reliability, is provided.

### Brief Description of Drawings

Fig. 1 is the DSC profile of the curing composition of Example 1.
Fig. 2 is the dynamic DSC profile of the curing composition of Comparative Example 4.
Fig. 3 is the isothermal DSC profile of the curing composition of Example 1.
Fig. 4 is an SEM cross-sectional view, taken after the curing process, of the underfill for flip-chip package obtained by curing the composition of Example 1.
Fig. 5 is an SEM cross-sectional view, taken after the underfill underwent the moisture absorption process followed by the IR reflow, of the underfill for flip-chip package obtained by curing the composition of Example 1.

### Detail Description of the Invention

In the present invention, the number average molecular weight (Mₙ) is determined by gel permeation chromatography (GPC) using polystyrene as a standard.

In the present invention, the viscosity (cps) and thixotropic index are determined by Brookfield HBDV III, at 25°C, humidity 50%, spindle 51, and a rotational speed of 0.5 rpm/5 rpm.

### 1. Latent curing composition

### 1.1 Epoxy resin (A)

Since the latent curing composition of the present invention contains an epoxy resin (A), a cured composition obtained by curing the latent curing composition has advantageous physical and chemical properties. Specifically, due to the superior non-conductivity, and water and chemical resistance of epoxy resins, the latent curing composition of the present invention is particularly suitable for adhesives for electronic devices, such as electronic circuits.

The epoxy resin (A) may be an epoxy resin having two or more epoxy groups in one molecule, and having a main skeleton formed of any type of oligomer. The epoxy resin (A) preferably has a main skeleton formed of a phenol-based oligomer. For example, such an epoxy resin (A) is obtainable by a condensation reaction of a phenol compound and an epichlorohydrin (ECH).

The epoxy resin (A) is preferably a liquid epoxy resin. In this context, the above liquid epoxy resin preferably refers to one that is liquid at 25°C; the same applies to the following. Alternatively, the epoxy resin (A) as such may preferably be a solid epoxy resin that becomes liquid, preferably at 25°C, in the presence of an appropriate diluent such as epoxy monomers and the like. In this context, the above solid epoxy resin preferably refers to one that is solid at 25°C; the same applies to the following.

The epoxy resin (A) may be composed of one type of epoxy resin, or may be a mixture of two or more types of epoxy resins. In this context, when the epoxy resin (A) is composed of two or more types of epoxy resins, the epoxy resin (A) may comprise liquid and solid epoxy resins; however, the epoxy resin (A) preferably shows a liquid state as a whole, optionally in the presence of the appropriate diluent, preferably at 25°C.

Examples of the epoxy resin (A) include bisphenol F-type epoxy resin, bisphenol A-type epoxy resin, alicyclic epoxy resin, allylbisphenol-type epoxy resin, and mixtures thereof. A bisphenol F-type epoxy resin is preferable as the epoxy resin (A), since it has low viscosity and low Cl content, while retaining other favorable properties that are similar to those of a bisphenol A-type epoxy resin.

In view of ease of imparting the appropriate viscosity to the latent curing composition, the epoxy resin (A) preferably has a molecular weight of 100 to 500, more preferably 100 to 400, and even more preferably 100 to 300.

In view of ease of imparting the appropriate viscosity to the latent curing composition, the epoxy resin (A) preferably has a viscosity of 300 cps to 6000 cps, more preferably 500 cps to 3000 cps, and even more preferably 1000 cps to 2000 cps.

Specific examples of the liquid epoxy resin include Epiclon® EXA830 CRP (epoxy equivalent 165-177 g/eq), Epiclon® EXA 835 LV (epoxy equivalent 165 g/eq) and Epiclon® EXA850 CRP (epoxy equivalent 168-178 g/eq) manufactured by DIC, Epon resin 825 (epoxy equivalent 175-180 g/eq) manufactured by Hexion Inc., Araldite® PY 306 (epoxy equivalent 156-167 g/eq) and Araldite® GY 285 (epoxy equivalent 164-172) manufactured by Huntsman International LLC, Epotohto® YDF-8170 (epoxy equivalent 158 g/eq) manufactured by Tohto Kasei Co., Ltd. as the bisphenol F-type epoxy resin; DER-332 (epoxy equivalent 170 g/eq) manufactured by The Dow Chemical Company, and YL 980 and YL 983U (epoxy equivalent 170 g/eq) manufactured by Japan Epoxy Resins Co., Ltd. as the bisphenol A-type epoxy resin; and Celloxide 2021 (epoxy equivalent 135 g/eq) manufactured by Daicel Chemical Industries, Ltd. as the alicyclic epoxy resin.

The latent curing composition of the present invention preferably contains the epoxy resin (A) in an amount of 10 to 50% by weight, more preferably in an amount of 10 to 25% by weight, based on the total weight of the latent curing composition.

### 1.2 Imidazole curing agent (B)

The latent curing composition of the present invention further contains an imidazole curing agent (B) having at least one primary amine group. This allows fast curing while imparting latency to the curing composition.

Specifically, while not wishing to be bound by theory, it is believed that the presence of at least one primary amine group in the imidazole curing agent (B) allows fast curing, since the reaction rate of the primary amine with an epoxy resin is very fast; for example, the reaction rate of the primary amine is much faster than that of a secondary amine. In this context, the imidazole curing agent (B) preferably has two or more primary amine groups, more preferably two to four primary amine groups, even more preferably two or three primary amine groups, and most preferably two primary amine groups.

The imidazole curing agent (B) is preferably represented by the following general formula (1), 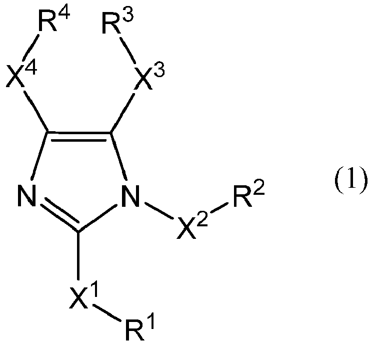 wherein
X¹, X², X³, and X⁴ may be the same or different, and each represents:
   a single bond; or
   a divalent hydrocarbon group having 1 to 20 carbon atoms, optionally interrupted with at least one member selected from the group consisting of an oxygen atom, a sulfur atom, a carbonyl group, an ester group, an amido group, and an imido group, of which at least one hydrogen atom is optionally replaced by a primary amine group,
R¹, R², R³, and R⁴ may be the same or different, and each represents:
   (a) a hydrogen atom;
   (b) a primary amine group, a halogen atom, or an electron-withdrawing group Y; or
   (c) a carbocyclic or heterocyclic ring having 3 to 10 ring atoms, of which at least one hydrogen atom is optionally replaced by the group or the atom (b),
   R³ and R⁴ are alternatively linked to each other to form a carbon ring or a heterocyclic ring having 3 to 10 ring atoms, and
   at least one of the following requirements is met:
   (i) at least one of R¹, R², R³, and R⁴ has a halogen atom or the electron-withdrawing group Y;
   (ii) at least one of R¹, R², R³, and R⁴ represents the carbocyclic or heterocyclic ring (c); and
   (iii) R³ and R⁴ are linked to each other to form an aromatic ring.

In the above general formula (1), the divalent hydrocarbon group may be saturated or unsaturated, and optionally branched.

In the above general formula (1), the carbocyclic or heterocyclic ring (c) may be saturated or unsaturated.

In the above general formula (1), the carbon ring or a heterocyclic ring formed by R³ and R⁴ may be saturated or unsaturated, and optionally substituted. Examples of the substituent include the group or the atom (b).

While not wishing to be bound by theory, it is believed that the above imidazole curing agent (B) is preferable for the following reasons x) to z):
x) the above imidazole curing agent (B) has a tertiary amine group that can catalytically promote homopolymerization of epoxy resins, and can also accelerate the reaction of primary and secondary amines with epoxy resins, thus accomplishing faster curing;
y) the above imidazole curing agent (B) may have a halogen atom or the electron-withdrawing group Y, or an aromatic ring fused onto itself, which allows electron withdrawal from the imidazole ring and thereby decreases the reactivity of the tertiary amine on the imidazole ring, thus imparting latency to the curing composition; and
z) the above imidazole curing agent (B) may have a carbocyclic or heterocyclic ring, which imparts latency to the curing composition due to its higher melting point, i.e., greater heat resistance, and lower miscibility with the epoxy resins at room temperature.

In view of the above x), the imidazole curing agent (B) preferably has at least two primary amine groups. In this context, the imidazole curing agent (B) has preferably two to four primary amine groups, more preferably two or three primary amine groups, and even more preferably two primary amine groups.

In view of the above y), the electron-withdrawing group Y is preferably a cyano group, a carboxyl group, or a hydroxyl group.

In view of the above z), the carbocyclic or heterocyclic ring (c) preferably has 3 to 10 ring atoms, more preferably has 5 to 8 ring atoms, even more preferably has 5 or 6 ring atoms, even further more preferably is an azole or azine ring, and most preferably is a triazine ring. In this context, the triazine ring may be 1,2,3-triazine, 1,2,4-triazine, or 1,2,5-triazine. 1,2,5-triazine is most preferable as the triazine ring.

In view of the above z), the imidazole curing agent (B) preferably has a melting point of 100°C or more, more preferably 150°C or more.

In the above general formula (1), when any of R¹, R², R³, and R⁴ represents a halogen atom, the electron-withdrawing group Y, or the carbocyclic or heterocyclic ring (c), the corresponding X¹, X², X³, and X⁴ preferably represents a single bond or a divalent hydrocarbon group, optionally interrupted with at least one member selected from the group consisting of an oxygen atom, a sulfur atom, a carbonyl group, an ester group, an amido group, and an imido group, of which at least one hydrogen atom is optionally replaced by a primary amine group, having 1 to 4 carbon atoms, more preferably having 1 to 3 carbon atoms, even more preferably having 1 or 2 carbon atoms.

In the above general formula (1), when one or more of R¹, R², R³, and R⁴ represents a halogen atom, or the electron-withdrawing group Y, or the carbocyclic or heterocyclic ring (c), each of the rest of R¹ , R², R³, and R⁴ preferably represents a hydrogen atom, and the corresponding X¹, X², X³, and X⁴ preferably represents a single bond or a divalent hydrocarbon group, optionally interrupted with at least one member selected from the group consisting of an oxygen atom, a sulfur atom, a carbonyl group, an ester group, an amido group, and an imido group, of which at least one hydrogen atom is optionally replaced by a primary amine group, having 1 to 12 carbon atoms, more preferably having 1 to 8 carbon atoms, even more preferably having 1 to 6 carbon atoms, even further more preferably having 1 to 3 carbon atoms, most preferably having 1 or 2 carbon atoms.

In one embodiment, at least one of R¹, R², R³, and R⁴ represents a carbocyclic or heterocyclic ring, of which at least one hydrogen atom is replaced by a primary amine group, preferably having 3 to 10 ring atoms, more preferably having 5 to 8 ring atoms, even more preferably having 5 or 6 ring atoms, even further more preferably being an azole or azine ring, still even further more preferably being a triazine ring, most preferably being a 1,2,5-triazine.

In the above embodiment, preferably at least R² represents a carbocyclic or heterocyclic ring, of which at least one hydrogen atom is replaced by a primary amine group, preferably having 3 to 10 ring atoms, more preferably having 5 to 8 ring atoms, even more preferably having 5 or 6 ring atoms, even further more preferably being an azole or azine ring, still even further more preferably being a triazine ring, most preferably being a 1,2,5-triazine.

In the above embodiments, it is preferable that two hydrogen atoms of the carbocyclic or heterocyclic ring are replaced by a primary amine group.

In the above embodiments, when one or more of R¹, R², R³, and R⁴ represents the carbocyclic or heterocyclic ring (c), each of the rest of R¹, R², R³, and R⁴ preferably represents a hydrogen atom, and the corresponding X¹, X², X³, and X⁴ preferably represents a single bond or a divalent hydrocarbon group, optionally interrupted with at least one member selected from the group consisting of an oxygen atom, a sulfur atom, a carbonyl group, an ester group, an amido group, and an imido group, of which at least one hydrogen atom is optionally replaced by a primary amine group, having 1 to 12 carbon atoms, more preferably having 1 to 8 carbon atoms, even more preferably having 1 to 6 carbon atoms, even further more preferably having 1 to 3 carbon atoms, most preferably having 1 or 2 carbon atoms.

Thus, a preferable example of the imidazole curing agent (B) is represented by the above general formula (1):
wherein R² represents a carbocyclic or heterocyclic ring, of which two hydrogen atoms are replaced by a primary amine group, having 3 to 10 ring atoms, preferably having 5 to 8 ring atoms, more preferably having 5 or 6 ring atoms, even more preferably being an azole or azine ring, even further more preferably being a triazine ring, and most preferably being a 1,2,5-triazine;
wherein X² represents a single bond or a divalent hydrocarbon group, optionally interrupted with at least one member selected from the group consisting of an oxygen atom, a sulfur atom, a carbonyl group, an ester group, an amido group, and an imido group, having 1 to 4 carbon atoms; and
wherein each of R¹, R³, and R⁴ represents (a) a hydrogen atom, and each of X¹, X³, and X⁴ represents a single bond or a divalent hydrocarbon group, optionally interrupted with at least one member selected from the group consisting of an oxygen atom, a sulfur atom, a carbonyl group, an ester group, an amido group, and an imido group, of which at least one hydrogen atom is optionally replaced by a primary amine group, having 1 to 12 carbon atoms.

A more preferable example of the imidazole curing agent (B) is represented by the above general formula (1):
wherein R² represents a carbocyclic or heterocyclic ring, of which two hydrogen atoms are replaced by a primary amine group, having 3 to 10 ring atoms, preferably having 5 to 8 ring atoms, more preferably having 5 or 6 ring atoms, even more preferably being an azole or azine ring, even further more preferably being a triazine ring, and most preferably being a 1,2,5-triazine; and
wherein X² represents a single bond or a divalent hydrocarbon group, optionally interrupted with at least one member selected from the group consisting of an oxygen atom, a sulfur atom, a carbonyl group, an ester group, an amido group, and an imido group, having 1 to 4 carbon atoms; and
wherein each of R¹, R³, and R⁴ represents (a) a hydrogen atom, and the corresponding X¹, X³, and X⁴ represents a single bond or a divalent hydrocarbon group, optionally interrupted with at least one member selected from the group consisting of an oxygen atom, a sulfur atom, a carbonyl group, an ester group, an amido group, and an imido group, having 1 or 2 carbon atoms.

Alternatively, a more preferable example of the imidazole curing agent (B) is represented by the above general formula (1):
wherein R² represents a carbocyclic or heterocyclic ring, of which two hydrogen atoms are replaced by a primary amine group, having 3 to 10 ring atoms, preferably having 5 to 8 ring atoms, more preferably having 5 or 6 ring atoms, even more preferably being an azole or azine ring, even further more preferably being a triazine ring, and most preferably being a 1,2,5-triazine;
wherein X² represents a single bond or a divalent hydrocarbon group, optionally interrupted with at least one member selected from the group consisting of an oxygen atom, a sulfur atom, a carbonyl group, an ester group, an amido group, and an imido group, having 1 or 2 carbon atoms; and
wherein each of R¹, R³, and R⁴ represents (a) a hydrogen atom, and the corresponding X¹, X³, and X⁴ represents a single bond or a divalent hydrocarbon group, optionally interrupted with at least one member selected from the group consisting of an oxygen atom, a sulfur atom, a carbonyl group, an ester group, an amido group, and an imido group, having 1 to 12 carbon atoms.

An even more preferable example of the imidazole curing agent (B) is represented by the above general formula (1):
wherein R² represents a carbocyclic or heterocyclic ring, of which two hydrogen atoms are replaced by a primary amine group, having 3 to 10 ring atoms, preferably having 5 to 8 ring atoms, more preferably having 5 or 6 ring atoms, even more preferably being an azole or azine ring, even further more preferably being a triazine ring, and most preferably being a 1,2,5-triazine;
wherein X² represents a single bond or a divalent hydrocarbon group, optionally interrupted with at least one member selected from the group consisting of an oxygen atom, a sulfur atom, a carbonyl group, an ester group, an amido group, and an imido group, having 1 or 2 carbon atoms; and
wherein each of R¹, R³, and R⁴ represents (a) a hydrogen atom, and the corresponding X¹, X³, and X⁴ represents a single bond or a divalent hydrocarbon group, optionally interrupted with at least one member selected from the group consisting of an oxygen atom, a sulfur atom, a carbonyl group, an ester group, an amido group, and an imido group, having 1 or 2 carbon atoms.

The imidazole curing agent (B) may be in the form of an acid adduct. Examples of such acid adducts include isocyanuric acid adducts, trimellitic acid adducts, and the like.

Specific examples of the imidazole curing agent (B) include 2MZ-A (2,4-diamino-6-[2-(2-methyl-1-imidazolyl)ethyl]-1,3,5-triazine), C11Z-Azine (2,4-diamino-6-[2-(2-undecyl-1-imidazolyl)ethyl]-1,3,5-triazine), 2MA-OK (2,4-diamino-6-[2-(2-methyl-1-imidazolyl)ethyl]-1,3,5-triazine isocyanuric acid adduct dehydrate), and 2E4MZ-A (2,4-diamino-6-[2-(2-ethyl-4-methyl-1-imidazolyl)ethyl]-1,3,5-triazine) manufactured by Shikoku Chemicals Corporation.

The imidazole curing agent (B) may be composed of one type of imidazole curing agent, or may be a mixture of two or more types of imidazole curing agents.

The latent curing composition of the present invention contains the imidazole curing agent (B) preferably in an amount of 1 to 15% by weight, more preferably in an amount of 3 to 10% by weight, based on the total weight of the latent curing composition.

### 1.3 Multifunctional epoxy monomer (C)

The latent curing composition of the present invention may further contain a multifunctional epoxy monomer (C). In the process of curing the latent curing composition of the present invention, an epoxy resin (A) reacts with the multifunctional epoxy monomer (C) as well as with itself, thus accomplishing faster curing performance. Moreover, more highly cross-linked epoxy resin results from such a curing process in the presence of the multifunctional epoxy monomer (C). This allows the Tg of the cured latent curing composition to be relatively high.

The liquid adhesive composition of the present invention may comprise one or more types of multifunctional epoxy monomer (C).

In view of fast curing performance, the multifunctional epoxy monomer (C) is preferably tri- or more functional epoxy monomer, such as trifunctional, tetrafunctional, pentafunctional, hexafunctional, heptafunctional, octafunctional, nonafunctional, and decafunctional epoxy monomer.

The multifunctional epoxy monomer (C) is preferably a trifunctional, tetrafunctional, pentafunctional, or hexafunctional epoxy monomer, more preferably trifunctional, tetrafunctional, or pentafunctional epoxy monomer, even more preferably trifunctional or tetrafunctional epoxy monomer, in view of fast curing performance while retaining other properties of the latent curing composition, such as viscosity and the like. In this context, the multifunctional epoxy monomer (C) is preferably an amine-based compound, more preferably a phenyl amine-based compound.

Suitable multifunctional epoxy monomer (C) for use in the presentinvention may be selected from the group consisting of triglycidylized p-aminophenol, tris-(hydroxyl phenyl) methane-based epoxy, Trimethylolpropane triglycidyl ether, hydroxyl-terminated epoxidized polybutadiene and mixtures thereof.

Specific examples of the multifunctional epoxy monomer (C) include Araldite® MY 0510 (triglycidylized p-aminophenol; epoxy equivalent 95-106 g/eq), Tactix® 742 (tris-(hydroxyl phenyl) methane-based epoxy; epoxy equivalent 150-170 g/eq) manufactured by Huntsman International LLC, Heloxy™ Modifier 48 manufactured by Momentive (Trimethylolpropane triglycidyl ether; epoxy equivalent 138-154 g/eq), TECHMORE VG-3101L manufactured by Printec Co., Ltd. (epoxy equivalent 210 g/eq), and Poly BD® 605 E (hydroxyl-terminated epoxidized polybutadiene) manufactured by Sartomer Co. (epoxy equivalent 260-330 g/eq).

The multifunctional epoxy monomer (C) may be composed of one type of multifunctional epoxy monomer, or may be a mixture of two or more types of multifunctional epoxy monomers.

The latent curing composition of the present invention contains the multifunctional epoxy monomer (C) preferably in an amount of 5 to 25% by weight, more preferably in an amount of 5 to 15% by weight, based on the total weight of the latent curing composition.

### 1.4 Other components

The latent curing composition of the present invention may contain other components in addition to the epoxy resin (A), the imidazole curing agent (B), and optionally the multifunctional epoxy monomer (C). Examples of other components include a rubber modified epoxy resin, an epoxy diluent, a filler, a silane coupling agent, a surfactant, a fluxing agent, a silicone modifier, and an ion catcher.

### 1.4.1 Rubber modified epoxy resin

The latent curing composition of the present invention may contain a rubber modified epoxy resin to impart flexibility to the composition.

The latent curing composition of the present invention may contain at least one rubber modified epoxy resin selected from the group consisting of hydroxyl-terminated epoxidized polybutadiene, epoxidized polybutadiene, CTBN-modified diglycidylether of bisphenol A, CTBN-modified diglycidylether of neopentyl glycol and mixtures thereof.

Specific examples of the rubber modified epoxy resin include Poly BD® 605 E (hydroxyl-terminated epoxidized polybutadiene) manufactured by Sartomer Co.; Epolead PB 3600 (epoxidized polybutadiene) manufactured by Daicel Corporation; and Epon 58005,58006, and 58901 (CTBN-modified diglycidylether of bisphenol A), and 58034 and 58120 (CTBN-modified diglycidylether of neopentyl glycol) manufactured by Momentive Performance Materials, Inc.

The rubber modified epoxy resin may be composed of one type of rubber modified epoxy resin, or may be a mixture of two or more types of rubber modified epoxy resins.

The latent curing composition of the present invention contains the rubber modified epoxy resin preferably in an amount of 0.5 to 10% by weight, more preferably in an amount of 1 to 5% by weight, based on the total weight of the latent curing composition.

### 1.4.2 Epoxy diluent

The latent curing composition of the present invention may contain an epoxy diluent to control rheology of the composition.

The latent curing composition of the present invention may contain at least one epoxy diluent selected from the group consisting of glycidyl neodecanoate, 4-tert-butylphenyl glycidyl ether, glycidyl 2-methylphenyl ether, 1,6-hexanediol diglycidyl ether and mixtures thereof.

Specific examples of the epoxy diluent include Cardura E 10 P (glycidyl neodecanoate) manufactured by Hexion Inc.; ED 509 S (4-tert-butylphenyl glycidyl ether) manufactured by ADEKA Corporation; Erisys® GE-10 (glycidyl 2-methylphenyl ether) manufactured by CVC Thermoset Specialties; and Denacol® EX-L series, including EX 212 L (1,6-hexanediol diglycidyl ether), manufactured by Nagase & Co., Ltd.

The epoxy diluent may be composed of one type of epoxy diluent, or may be a mixture of two or more types of epoxy diluents.

The latent curing composition of the present invention contains the epoxy diluent preferably in an amount of 1 to 15% by weight, more preferably in an amount of 1 to 10% by weight, based on the total weight of the latent curing composition.

### 1.4.3 Filler

The latent curing composition of the present invention may contain a filler to control rheology and enhance the warpage property of the composition. The filler is preferably a submicron silica filler.

Specific examples of the filler include Admafine® SO-E1, SO-E2, SO-E3, SO-E5, and SO-E6, and SO-C1 to SO-C6, manufactured by Admatechs Co., Ltd.; FB-01 and SFP-30M manufactured by Denka Co., Ltd.; and TSS-3D, EXV-3, PLV-3D, and EXV-3 (LVS) manufactured by Tatsumori, Ltd. The latent curing composition of the present invention may contain at least one filler selected from the group consisting of the above fillers.
The filler may be composed of one type of filler, or may be a mixture of two or more types of fillers.

The latent curing composition of the present invention contains the filler preferably in an amount of 30 to 70% by weight, more preferably in an amount of 40 to 60% by weight, based on the total weight of the latent curing composition.

### 1.4.4 Silane coupling agent

The latent curing composition of the present invention may contain a silane coupling agent to couple organic and inorganic components in the composition. The silane coupling agent may be an epoxy-functional silane. The silane coupling agent preferably has an aromatic structure to impart properties that are similar to the other components including the epoxy resin (A) to the composition.

The latent curing composition of the present invention may contain at least one silane coupling agent selected from the group consisting of [2-(3,4-epoxycyclohexyl)ethyl]trimethoxysilane, 3-(trimethoxysilyl)propyl methacrylate, 2-(3,4-epoxycyclohexyl)ethyltrimethoxysilane, 2-(3,4-epoxycyclohexyl)ethyltrimethoxysilane, 3-glycidyloxypropyltrimethoxysilane and mixtures thereof.

Specific examples of the silane coupling agent include Silquest A-186 ([2-(3,4-epoxycyclohexyl)ethyl]trimethoxysilane) and SilquestA-174 (3-(trimethoxysilyl)propyl methacrylate) manufactured by Momentive Performance Materials, Inc., KBM-303 (2-(3,4-epoxycyclohexyl)ethyltrimethoxysilane) manufactured by Shin-Etsu Chemical, SIE 4670.0 (2-(3,4-epoxycyclohexyl)ethyltrimethoxysilane) manufactured by Gelest, Inc., and Z-6040 (3-glycidyloxypropyltrimethoxysilane) manufactured by Dow Corning Corporation.

The silane coupling agent may be composed of one type of silane coupling agent, or may be a mixture of two or more types of silane coupling agents.

The latent curing composition of the present invention contains the silane coupling agent preferably in an amount of 0.01 to 5% by weight, more preferably in an amount of 0.5 to 1 % by weight, based on the total weight of the latent curing composition.

The latent curing composition of the present invention preferably contains a solid content in an amount of 40 to 80% by weight, more preferably 50 to 60% by weight, based on the total weight of the latent curing composition.

### 2. Use of the latent curing composition

The latent curing composition of the present invention can be used as an adhesive, preferably as a nonconductive adhesive (NCA), due to the excellent non-conductivity imparted by the epoxy resin (A).

Moreover, the latent curing composition of the present invention is not cured at room temperature, but at a somewhat higher temperature, preferably at 100°C or higher, more preferably at 150°C or higher, while curing fast.

Thus, the latent curing composition of the present invention is preferably a thermocompression bonding-type latent curing composition. Specifically, the latent curing composition of the present invention can be used as a thermocompression (TC) adhesive, preferably TC-NCA.

For example, the latent curing composition of the present invention can be used as an underfill in manufacturing a flip chip package.

### Examples

The present invention is explained below in more detail with reference to Examples and Comparative Examples. However, the scope of the invention is not limited to the Examples.

### Example 1

The components shown in Table 1 were fully stirred and mixed to produce a curing composition.

**Table 1**

| **Components** | **Product names** | **Weight (g)** |
|---|---|---|
| **Epoxy resin (bisphenol F-type epoxy resin)** | Epiclon® EXA830 CRP (DIC) | 20.50 |
| **Imidazole curing agent** | 2MZ-A (Shikoku Chemicals) | 6.00 |
| **Multifunctional epoxy monomer** | Araldite® MY 0510 (Huntsman) | 10.03 |
| **Rubber modified epoxy resin** | Poly BD® 605 E (Sartomer) | 1.85 |
| **Epoxy diluent** | Cardura E 10 P (Hexion) | 6.02 |
| **Filler A (fine silica; particle size 0.5 um)** | Admafine® SO-E2 (Admatech) | 26.0 |
| **Filler B (particle size 1.5 um)** | Admafine® SO-E5 (Admatech) | 26.0 |
| **Silane coupling agent** | Silquest A-186 (Momentive) | 0.50 |
| **Silicone rubber powder** | KMP-598 (Shin-Etsu Chemical) | 3.00 |
| **Surfactant** | BYK W 0910 (BYK) | 0.10 |

### Comparative Example 1

A curing composition was obtained in the same manner as in Example 1, except that the amine adducted curing agent PN-23, manufactured by Ajinomoto, was used as a curing agent instead of 2MZ-A.

### Comparative Example 2

A curing composition was obtained in the same manner as in Example 1, except that the amine adducted curing agent HXA3932 HP, manufactured by Asahi Kasei, was used as a curing agent instead of 2MZ-A.

### Comparative Example 3

A curing composition was obtained in the same manner as in Example 1, except that a dicyandiamide (DICY) manufactured by A&C Catalysts was used as a curing agent instead of 2MZ-A.

### Comparative Example 4

A curing composition was obtained in the same manner as in Example 1, except that 2MZ (2-methyl imidazole; Shikoku Chemicals) was used as a curing agent instead of 2MZ-A.

The curing compositions thus obtained were subjected to dynamic DSC measurements, as shown in Table 2.

**Table 2**

| **Test item** | **Equipment** | **Measurement** | **Specimen preparation** | **Test conditions** |
|---|---|---|---|---|
| DSC-Heating | TA DSC Q2000 | Onset, Peak, Enthalpy | None | Temp: 40-250°C, Ramp up: 10°C/min |

The curing composition obtained in Example 1 was also subjected to isothermal DSC measurements in the same manner as above, but under the test conditions shown below.
Step 1. Isothermal 70°C for 2 hours
Step 2. Heated to 250°C at 10°C/min

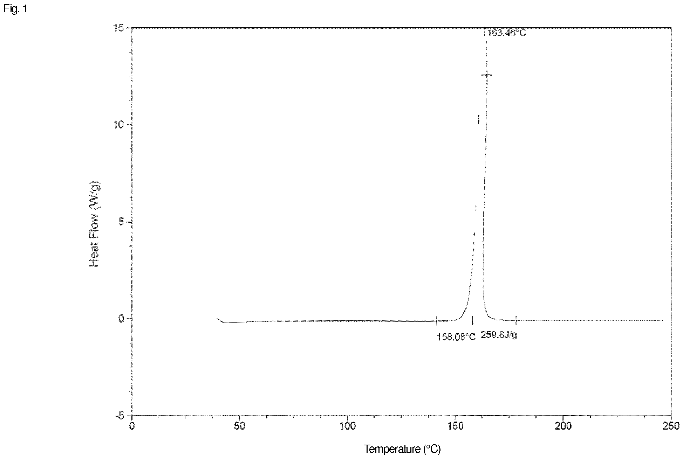

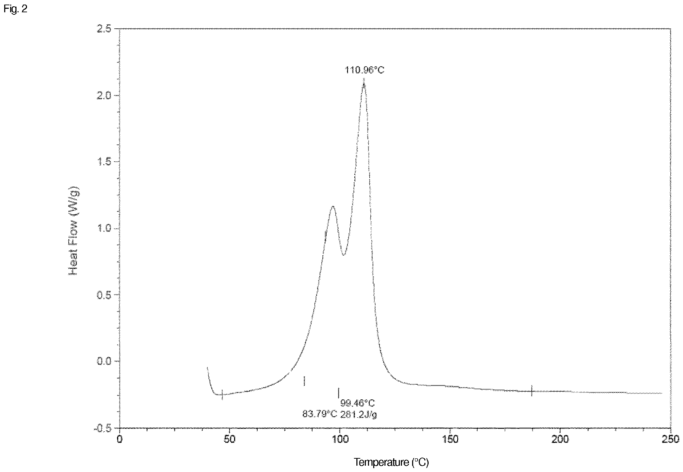

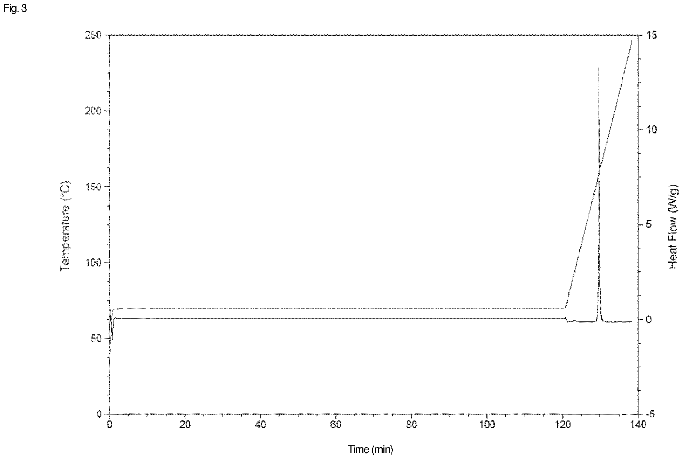

Figures 1 and 2 show the dynamic DSC measurement results of Example 1 and Comparative Example 4, respectively. Figure 3 shows the isothermal DSC measurement results of Example 1. It was revealed that the curing speed of Example 1 is much faster than that of Comparative Example 4. Those results also show that the curing composition of Example 1 cures at a higher temperature than Comparative Example 4. Moreover, such a fast curing speed was not achieved in either Comparative Example 2 or 3.

Viscosity measurement at 25°C, humidity 50% was conducted by time for Example 1 and Comparative Example 4. The results are shown in Table 3. It was revealed that greater latency is achieved in Example 1 than in Comparative Example 4.

**Table 3**

| **Time (h)** | **Rotation speed (rpm)** | **Example 1 (cps)** | **Comparative Example 4 (cps)** |
|---|---|---|---|
| 0 | 0.5 | 106045 | 157411 |
| | 5 | **19884** | 33636 |
| | T.I. | 5.3 | 4.7 |
| 24 | 0.5 | 72078 | Gelation |
| | 5 | **19626** | |
| | T.I. | 3.7 | |
| 48 | 0.5 | 57165 | Gelation |
| | 5 | **19469** | |
| | T.I. | 2.9 | |
| 72 | 0.5 | 51366 | Gelation |
| | 5 | **19386** | |
| | T.I. | 2.6 | |
| 168 | 0.5 | 36453 | Gelation |
| | 5 | **18724** | |
| | T.I. | 1.9 | |

The die shear strength was evaluated for the curing composition of Example 1, as shown in Table 4. The die shear strength was measured at 25°C and 250°C, and the results are shown in Table 5. It was revealed that the curing composition of Example 1 exhibits good die shear strength.

**Table 4**

| **Equipment** | **Specimen preparation** | **Test Conditions** |
|---|---|---|
| UTM Dage 4000Plus | Cure: RT to 160°C | Speed: 600 um/s |
| | Ramp up: 30 min | |
| | 160°C/2 hours | |
| | Substrate: FR-5 laminate (a glass fabric reinforcement in a high-temperature epoxy resin binder) | |
| | Chip: SiN | |

**Table 5**

| **Temperature** | **Die shear strength (kgf)** |
|---|---|
| 25°C | 18.1 |
| 250°C | 6.1 |

Moreover, the reliability of a cured composition obtained by curing the composition of Example 1 was tested as follows. The curing composition of Example 1 was used as an underfill for a flip-chip package having a flip-chip of 60 x 60 mm and a bump of Cu pillar with an inner bump pitch of 80 um and outer bump pitch of 40 um. The substrate was made of Cu. TC bonding was conducted with a bonding force of 100 N, peak temperature of 250°C, and dwell time of 10 seconds. The SEM cross-sectional view of the thus-obtained underfill is shown in Figure 3.

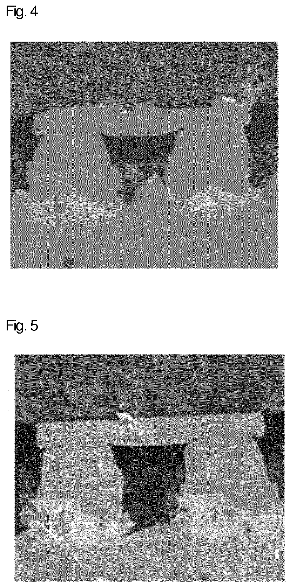

The thus-obtained underfill was subjected to moisture absorption at 168 hours at 85°C, humidity 85%, followed by three-time IR reflow at 260°C. As shown in the SEM cross-sectional view of the thus-treated underfill (Figure 4), no cracking occurred after such a treatment.

## Claims

1. A latent curing composition comprising:
(A) an epoxy resin; and
(B) an imidazole curing agent having at least one primary amine group.

2. The latent curing composition according to claim 1, wherein the imidazole curing agent (B) is represented by the following general formula (1), 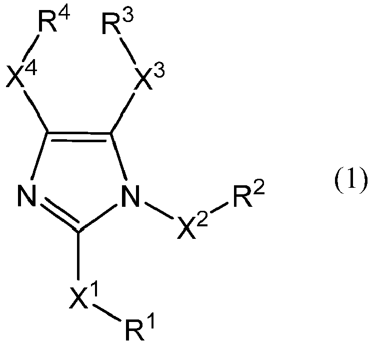 wherein
X¹, X², X³, and X⁴ may be the same or different, and each represents:
a single bond; or
a divalent hydrocarbon group having 1 to 20 carbon atoms, optionally interrupted with at least one member selected from the group consisting of an oxygen atom, a sulfur atom, a carbonyl group, an ester group, an amido group, and an imido group, of which at least one hydrogen atom is optionally replaced by a primary amine group,
R¹, R², R³, and R⁴ may be the same or different, and each represents:
(a) a hydrogen atom;
(b) a primary amine group, a halogen atom, or an electron-withdrawing group Y; or
(c) a carbocyclic or heterocyclic ring having 3 to 10 ring atoms, of which at least one hydrogen atom is optionally replaced by the group or the atom (b),
R³ and R⁴ are alternatively linked to each other to form a carbon ring or a heterocyclic ring having 3 to 10 ring atoms, and
at least one of the following requirements is met:
(i) at least one of R¹ , R², R³, and R⁴ has a halogen atom or the electron-withdrawing group Y;
(ii) at least one of R¹, R², R³, and R⁴ represents the carbocyclic or heterocyclic ring (c); and
(iii) R³ and R⁴ are linked to each other to form an aromatic ring.

3. The latent curing composition according to claim 2, wherein the electron-withdrawing groups Y are selected from the group consisting of a cyano group, a carboxyl group, or a hydroxyl group.

4. The latent curing composition according to any one of claims 1 to 3, wherein the imidazole curing agent (B) has at least two primary amine groups.

5. The latent curing composition according to any one of claims 1 to 4, wherein the heterocyclic ring (c) is an azine ring.

6. The latent curing composition according to any one of claims 1 to 5, wherein the epoxy resin (A) is a bisphenol F-type epoxy resin.

7. The latent curing composition according to any one of claims 1 to 6, further comprising:
(C) a multifunctional epoxy monomer.

8. The latent curing composition according to any one of claims 1 to 7, wherein the latent curing composition is a thermocompression bonding-type latent curing composition.

9. The latent curing composition according to any one of claims 1 to 8, wherein the latent curing composition is cured at 100°C or higher.

10. The latent curing composition according to any one of claims 1 to 9, wherein the imidazole curing agent (B) has a melting point of 100°C or more.

11. Use of the latent curing composition according to any one of claims 1 to 10 as a nonconductive adhesive (NCA).

12. The use according to claim 11, wherein the NCA is a thermocompression NCA.

13. Use of the latent curing composition according to any one of claims 1 to 10 as an underfill in manufacturing a flip chip package.

14. An article comprising a cured composition obtainable by curing the latent curing composition according to any one of claims 1 to 10.

15. The article according to claim 14, wherein the article is a flip chip mounting body comprising the cured composition as an underfill in a flip chip package.
